# EUROPEAN PATENT APPLICATION

(11) **EP 2 037 489 A2**
(43) Date of publication of application: **18.03.2009**
(21) Application number: 08020525.5
(22) Date of filing: 12.01.2005
(51) Int. Cl.: H01L 21/027, G03F 7/20

(54) **Exposure apparatus and device producing method**

(30) Priority: 15.01.2004 JP 2004007948
(62) Divisional of application: 05703467.0
(71) Applicant: Nikon Corporation, Tokyo 100-8331 (JP)
(72) Inventor: Tsuji, Toshihiko, Tokyo (JP); Shiraishi, Kenichi, Tokyo (JP); Nagasaka, Hiroyuki, Tokyo (JP); Nakano, Katsushi, Tokyo (JP)
(74) Representative: HOFFMANN EITLE

(57) **Abstract**

The invention relates to an exposure apparatus (EX, EX2), in which the space between a projection optical system (30) which projects a pattern (PA) onto an object (W, 42) and said object placed on the image-plane side of said projection optical system is filled with a liquid, and exposure to said pattern is performed through the liquid. The apparatus comprises an opposing member (91, 92), positioned apart from said object (W, 42) in the direction of the optical axis (AX) of said projection optical system (30), a driving device (93) to drive the opposing member (91, 92) and a control device (70), which, in response to notification of occurrence of an abnormality, moves said object and said opposing member apart along said optical axis direction. The opposing member (91, 92) of the apparatus is movable, relative to the projection optical system (30), in the optical axis direction (AX).

## Description

### TECHNICAL FIELD

This invention relates to an exposure apparatus used in photolithography processes to manufacture highly integrated semiconductor circuit devices.

The present invention claims priority from Japanese Patent Application 2004-7948, filed on January 15, 2004 , the entire contents of which are incorporated herein by reference.

### BACKGROUND ART

Semiconductor devices and liquid crystal display devices are manufactured using so-called photolithography techniques, in which a pattern formed on a mask is transferred onto a photosensitive substrate. An exposure apparatus used in such photolithography processes has a mask stage which supports the mask and a substrate stage which supports the substrate; the mask pattern is transferred onto the substrate via a projection optical system, while successively moving the mask stage and substrate stage.

In order to accommodate the ever-higher integration levels of device patterns in recent years, projection optical systems with increasingly higher resolution have been sought. The shorter the wavelength of the exposure light used, and the larger the numerical aperture of the projection optical system, the higher is the resolution of the projection optical system. Consequently the exposure wavelengths used in an exposure apparatus have been moving to shorter wavelengths with each passing year, and the numerical apertures of projection optical systems have been increased. Currently the mainstream exposure wavelength is the 248 nm of KrF excimer lasers, but ArF excimer lasers at the still shorter wavelength of 193 nm are coming into use.

However, when the numerical aperture is increased while shortening the exposure wavelength, the depth of focus is reduced. In particular, when the depth of focus becomes too small, it becomes difficult to bring the substrate surface into coincidence with the image plane of the projection optical system, and there is the possibility that the margin may be insufficient during exposure operations.

Hence liquid immersion methods such as that for example disclosed in Patent Document 1 have been disclosed as methods to effectively shorten the exposure wavelength and to broaden the depth of focus. In this liquid immersion method, the interval between the lower surface of the projection optical system and the substrate surface is filled with water, an organic solvent, or another liquid, and the fact that the wavelength of the exposure light in the liquid is 1/n that in air (where n is the index of refraction of the liquid, normally approximately 1.2 to 1.6) to raise the resolution, while expanding the depth of focus by approximately n times.

Patent Document 1: International Patent Disclosure 99/49504

### DISCLOSURE OF INVENTION

### PROBLEM TO BE SOLVED BY THE INVENTION

However, in cases in which a liquid immersion method is applied and similar, the distance between the projection optical system and the substrate, or the distance between the liquid supply portion and liquid recovery portion and the substrate, must be brought into proximity of for example approximately 1 mm. Further, there are cases in which, due to various causes, the substrate tends to be inclined slightly relative to the projection optical system.

As a result, when the substrate is moved together with the substrate stage within the plane perpendicular to the projection optical system, there is the problem that the substrate and the projection optical system may interfere (collide), causing damage to the substrate and the exposure apparatus.

Further, due to errors in measurement of the substrate stage position, electrical noise and the like, the substrate stage may become uncontrollable and undergo runaway; or, in the event of an earthquake or other abnormality, there may be interference (collisions) between the substrate stage and projection optical system, or between the substrate stage and liquid supply portion and similar, so that the exposure apparatus may be damaged. The occurrence of such abnormalities is extremely rare, but in the event of such an occurrence, a considerable amount of time is required for restoration of the damaged an exposure apparatus, so that the production of semiconductor devices or the like is halted for a long period of time, and considerable harm results.

This invention was devised in light of the above circumstances, and has as an object the provision of an exposure apparatus capable of easily avoiding collisions between the projection optical system and substrate or substrate stage, even when the projection optical system is in close proximity to the substrate.

### MEANS FOR SOLVING PROBLEM

In an exposure apparatus and a device manufacturing method of this invention, the following constructions are adopted in order to resolve the above problems.

A first invention is an exposure apparatus (EX, EX2), comprising a projection optical system which projects and transfers a pattern (PA) formed on a mask (R) onto a substrate (W) and a substrate stage (42), positioned below the projection optical system, which while holding the substrate moves in directions substantially perpendicular to the direction of the optical axis (AX) of the projection optical system, and comprising a detector (81), positioned on the periphery of the projection optical system, which detects the position of the substrate stage or of the substrate along the optical axis direction, and a control device (70) which halts or reverses movement of the substrate stage based on the result of detection by the detector. According to this invention, the risk of collision of the substrate or substrate stage with the projection optical system can be detected in advance, so that by halting or reversing movement of the substrate stage, collisions of the substrate or substrate stage and the projection optical system can be avoided beforehand.

Further, if an elevating device (47) which moves the substrate stage (42) in the direction of the optical axis (AX) is comprised, and the control device (70), by operating the elevating device based on detection results of the detector (81) moves the substrate stage away from the projection optical system (30) along the optical axis direction, then, when risk of collision is detected by the detector, by driving the elevating device of the substrate stage to move the substrate and substrate stage away from the projection optical system, collision of the substrate or substrate stage with the projection optical system can be avoided.

Further, if the detector (81) is positioned at a plurality of positions (D) more distant than the stopping distance (S) of the substrate stage (42) in the direction substantially perpendicular to the optical axis (AX) from the projection optical system (30), then by positioning the detector at a plurality of positions more distant than the stopping distance of the substrate stage, the substrate stage, which is traveling toward the projection optical system, can be stopped before colliding with the projection optical system.

Further, if an vibration isolation device (300) which can move along the direction of the optical axis (AX) and supports the projection optical system (30) in a manner preventing vibrations is comprised, and the control device (70) operates the vibration isolation device to raise the projection optical system in the optical axis direction based on detection results of the detector (81), then when risk of collision is detected by the detector, by driving the vibration isolation device, the projection optical system is moved away from the substrate and substrate stage, so that collision of the substrate or substrate stage with the projection optical system can be avoided.

Further, if a second vibration isolation device (400) which can move along the direction of the optical axis (AX) and supports the substrate stage (42) in a manner preventing vibrations is comprised, and the control device (70) operates the second vibration isolation device to lower the substrate stage in the optical axis direction based on the results of the detector (81), then when risk of collision is detected by the detector, by driving the second vibration isolation device, the substrate and substrate stage are moved away from the projection optical system, so that collision of the substrate or substrate stage with the projection optical system can be avoided.

Further, if an exposure apparatus (EX, EX2), in which the space between a projection optical system (30) which projects a pattern (PA) onto an object (W, 42) and the object positioned on the image plane side of the projection optical system is filled with a liquid, comprises an opposing member (30, 91, 92) positioned at a distance from the object in the direction of the optical axis (AX) of the projection optical system and a control device (70) which, in response to notification of the occurrence of an abnormality, moves the object and the opposing member apart along the optical axis direction, then even in so-called liquid-immersion type an exposure apparatus, collision of the object with the opposing member can be avoided.

Further, if the control device (70) moves the object (W, 42) and the opposing member (30, 91, 92) apart along the direction of the optical axis (AX) in response to notification of the occurrence of an earthquake, then damage to the exposure apparatus due to the earthquake can be prevented, and so even when exposure processing is stopped due to an earthquake, exposure processing can be quickly resumed.

Further, if the object (W, 42) can move within the plane perpendicular to the optical axis (AX), and the control device (70) moves the object and the opposing member (30, 91, 92) apart along the optical axis direction in response to notification of an abnormal operation, the collision of the object with the opposing member can be avoided.

Further, if an elevating device (47) which moves the object (W, 42) in the direction of the optical axis (AX) and a driving device (300, 93) which drives the opposing member (30, 91, 92) in the optical axis direction are provided, and if the control device (70) controls at least one of the elevating device and the driving device to move the object and the opposing member apart along the optical axis direction, then by means of the elevating device and driving device, the object and the opposing member can be moved apart from each other, so that collisions between the object and the opposing member can be reliably avoided.

Further, if a first frame (110) which supports the opposing member (30, 91, 92) is comprised, and the driving device is an vibration isolation device (300) which supports the opposing member via the first frame so as to enable movement in the direction of the optical axis (AX), then existing devices can be used to move the opposing member in the optical axis direction, and avoidance of collisions between the object and the opposing member can be achieved while restraining equipment costs.

Further, if a second vibration isolation device (400), which supports the object (W, 42) so as to enable movement along the direction of the optical axis (AX), is further provided, and the control device (70) controls at least one of the elevating device (47), vibration isolation device (300), and second vibration isolation device (400) to move apart the object and the opposing member along the optical axis direction, then existing devices can be used to move the object in the optical axis direction, and avoidance of collisions between the object and the opposing member can be achieved while restraining equipment costs.

Further, if the driving device (93) drives the opposing member (91, 92) in the direction of the optical axis (AX) with respect to the projection optical system (30), then by driving the opposing member, positioned on the periphery of the projection optical system, in the optical axis direction, avoidance of collisions between the object and the opposing member can be achieved still more reliably.

Further, if the object (W, 42) is a substrate (W) exposed to a pattern (PA) or a substrate stage (42) holding a substrate, and moveable with at least three degrees of freedom, then collisions between the substrate or substrate stage and the opposing member can be avoided.

Further, if the opposing member (91, 92) comprises at least one of a liquid supply device (91) to supply liquid to, and a liquid recovery device (92) to recover liquid from, the space between the projection optical system (30) and the object (W, 42), then collisions between the substrate or table and the liquid supply device or liquid recovery device, positioned on the periphery of the projection optical system, can be avoided.

A second invention is a method of device manufacture comprising a lithography process, in which an exposure apparatus (EX) of the first invention is used in the lithography process. According to this invention, devices comprising fine patterns can be manufactured while avoiding collisions between the substrate or substrate stage and the projection optical system.

### EFFECT OF THE INVENTION

According to this invention, the following advantageous results can be obtained.

The first invention is an exposure apparatus having a projection optical system which projects and transfers a pattern formed on a mask onto a substrate and a substrate stage, positioned below the projection optical system, which while holding the substrate moves in directions substantially perpendicular to the direction of the optical axis of the projection optical system, and comprising a detector, positioned on the periphery of the projection optical system, which detects the position of the substrate stage or of the substrate along the optical axis direction, and a control device which halts or reverses movement of the substrate stage based on the result of detection by the detector.

According to this invention, the risk of collision of the substrate or substrate stage with the projection optical system can be detected by the detector in advance, so that by halting or reversing movement of the substrate stage, collisions of the substrate or substrate stage and the projection optical system can be avoided beforehand. Further, the frequency of repairs to the exposure apparatus can be reduced, so that the availability of the exposure apparatus can be improved.

Further, even in the case of the so-called liquid immersion-type an exposure apparatus, the risk of collision of the substrate or substrate stage with the projection optical system can be avoided. In particular, the risk of collision of a liquid supply device, liquid recovery device, or the like positioned on the periphery of the projection optical system and the substrate or substrate stage can be avoided.

The second invention is a method of device manufacture comprising a lithography process, in which an exposure apparatus of the first invention is used in the lithography process. According to this invention, collision of the projection optical system with the substrate stage can be avoided, so that the availability of the exposure apparatus can be improved, and devices can be manufactured efficiently.

### BRIEF DESCRIPTION OF THE DRAWINGS

FIG. 1 is a schematic diagram showing the configuration of an exposure apparatus according to a first embodiment;
FIG. 2 is a perspective view showing a wafer stage;
FIG. 3A is a schematic diagram showing a detection system and the like;
FIG. 3B is a schematic diagram showing a detection system and the like;
FIG. 4 is an enlarged view showing the lower-end portion of a projection optical system;
FIG. 5 is a schematic diagram showing the configuration of an exposure apparatus according to a second embodiment; and
FIG. 6 is a flowchart showing an example of semiconductor device manufacturing processes.

### DESCRIPTION OF THE REFERENCE SYMBOLS

| | |
|---|---|
| 30: | projection optical system (opposing member) |
| 42: | wafer table (substrate stage, object) |
| 43: | XY table (stage) |
| 47: | elevating device |
| 70: | control device |
| 81: | position detection sensor (detector) |
| 91: | liquid supply device (opposing member) |
| 92: | liquid recovery device (opposing member) |
| 93: | driving device |
| 110: | first support base (first frame) |
| 300: | vibration isolation unit (vibration isolation device) |
| 310: | air mount (driving device) |
| 400: | vibration isolation unit (second vibration isolation device) |
| 410: | air mount (elevating device) |
| S: | stopping distance |
| D: | distance |
| R: | reticle (mask) |
| W: | wafer (substrate, object) |
| PA: | pattern |
| AX: | optical axis |
| EX, EX2: | exposure apparatus |

### BEST MODE FOR CARRYING OUT THE INVENTION

Hereinafter, embodiments of an exposure apparatus and a device manufacturing method of this invention are explained, with reference to the drawings.

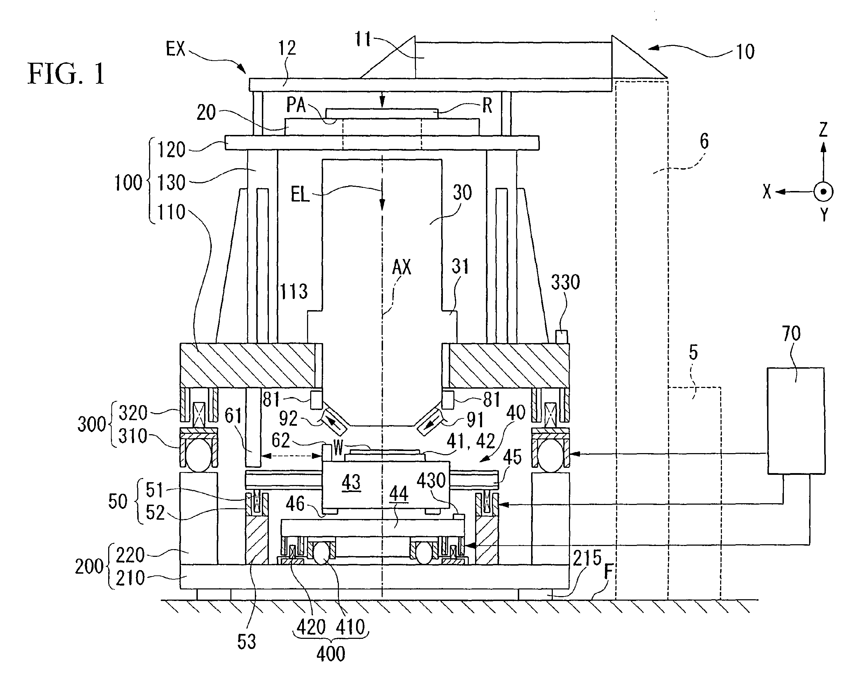

FIG. 1 is a schematic diagram showing the configuration of an exposure apparatus EX according to a first embodiment of the invention. The exposure apparatus EX is a step-and-scan type scanning exposure system, so-called, a scanning stepper which, while moving a reticle (mask) R and a wafer (substrate, object) W in a one-dimensional direction in sync, transfers a circuit pattern PA formed on the reticle R onto each shot area on the wafer W via a projection optical system 30.

In the following explanation, the direction coincident with the optical axis AX of the projection optical system 30 is taken to be the Z-axis direction, the direction of synchronized movement of the reticle R and wafer W within the plane perpendicular to the Z-axis direction (the scanning direction) is the Y-axis direction, and the direction perpendicular to the Z-axis direction and to the Y-axis direction (the non-scanning direction) is the X-axis direction. The directions about the X axis, Y axis, and Z axis are respectively the X, Y, and Z directions.

The exposure apparatus EX comprises an illumination optical system 10, which illuminates the reticle R with illuminating light; a reticle stage 20, which holds the reticle R; a projection optical system 30, which projects illuminating light emitted from the reticle onto a wafer W; a wafer stage 40, which holds the wafer W; a control device 70; and a detection system 80. These devices are each supported by a main unit frame 100 or base frame 200, via vibration isolation units 300 and 400 and the like.

The exposure apparatus EX is a liquid immersion exposure apparatus, which applies the liquid immersion method in order to effectively shorten the exposure wavelength and improve resolution as well as effectively broadening the depth of focus, and comprises a liquid supply device (opposing member) 91 which supplies liquid onto the wafer W, and a liquid recovery device (opposing member) 92 which recovers liquid on the wafer W. At least during the period in which the image of the pattern PA of the reticle R is being transferred onto the wafer W, the exposure apparatus EX forms a liquid immersion area in a portion of the area above the wafer W comprising the projection area of the projection optical system 30, by means of the liquid supplied from the liquid supply device 91. Specifically, the exposure apparatus EX fills the area between the optical element at the tip of the projection optical system 30 and the surface of the wafer W with a liquid, and projects the image of the pattern PA of the reticle R onto the wafer W via the liquid between the projection optical system 30 and wafer W and via the projection optical system 30, to expose the wafer W.

The illumination optical system 10 comprises a relay lens system, placed in a prescribed positional relation within a housing 11, and optical components such as mirrors to bend the optical path, condensing lenses and the like (none of them are shown). In the rear portion (on the right side in FIG. 1) of the main unit of the exposure apparatus EX are installed a light source 5 and illumination optical system separation portion 6, which are separated from the exposure apparatus EX in order that there is no transmission of vibrations.

A laser beam emitted from the light source 5 passes through the illumination optical system separation portion 6 and is incident on the illumination optical system 10; the cross-sectional shape of the laser beam is formed into a slit shape or a rectangular shape (polygonal shape), and becomes illuminating light (exposure light) EL, the illuminance distribution of which is substantially uniform, to illuminate the reticle R.

As the exposure light EL emitted from the illumination optical system 10, for example, far-ultraviolet light (DUV light), such as bright lines (the g line, h line, i line) in the ultraviolet range emitted from a mercury lamp and as KrF excimer laser light (of wavelength 248 nm); or vacuum ultraviolet light (VUV light), such as ArF excimer laser light (wavelength 193 nm), F₂ laser light (wavelength 157 nm), or the like is used. In this embodiment, ArF excimer laser light is used.

This illumination optical system 10 is supported by an illumination system support member 12, which is fixed in place on the upper surface of a second support base 120 constituting the main unit frame 100.

The reticle stage 20 comprises a reticle fine movement stage which holds the reticle R, a reticle coarse movement stage which moves, integrally with the reticle fine movement stage, with a prescribed stroke in the X-axis direction which is the scanning direction, and a linear motor or the like which moves these (none of them are shown). A rectangular aperture is formed in the reticle fine movement stage, and the reticle is held by vacuum suction by a reticle vacuum suction mechanism, provided in the vicinity of the periphery of the aperture, or by a similar mechanism. The two-dimensional position and rotation angle of the reticle fine movement stage, and the X-axis direction position of the reticle coarse movement stage, are measured with high precision by a laser interferometer (not shown) and based on the measurement results the position and speed of the reticle R are controlled.

This reticle stage 20 is held in suspension on the upper surface of the second support base 120 constituting the main unit frame 100 via a non-contact bearing (for example, a static-pressure air bearing).

As the projection optical system (opposing member) 30, a reducing system is used which reduces the image by a prescribed projection magnification (where is, for example, 1/5), and in which the object plane side (reticle side) and image plane side (wafer side) are both telecentric. Consequently, when the reticle is illuminated with illuminating light (pulsed ultraviolet light) from the illuminating optical system 10, an image-forming beam from the portion illuminated by the pulsed ultraviolet light among the pattern area formed on the reticle R is incident on the projection optical system 30, and a partial inverted image of the pattern PA is formed in the center of the field on the image plane side of the projection optical system 30, limited to a long and narrow slit shape or rectangular shape (polygon shape) in the X-axis direction, upon each illumination pulse of the pulsed ultraviolet light. By this means, a partial inverted image of the projected pattern PA is reduced and transferred onto one resist layer among a plurality of slot areas on the wafer W positioned in the image-forming plane of the projection optical system 30.

The optical element 32 positioned at the lower end of the projection optical system 30 is formed from fluorite. Fluorite has a high affinity for water, and so the liquid supplied to the space between the projection optical system 30 and the wafer W can be brought into close contact with substantially the entire surface on the lower-surface side of the optical element. The optical element positioned at the lower end of the projection optical system 30 may also be of quartz, which has a high affinity for water. Or, the lower side of the optical element may be subjected to hydrophilic (liquid affinity) treatment, to increase the affinity for the liquid.

A flange 31 is provided on the outer wall of the projection optical system 30, and the projection optical system 30 is inserted into a hole 113 provided in the first support base 110 constituting the main unit frame 100 and is supported via the flange 31. A kinematic mount (not shown) is provided between the projection optical system 30 and the first support base 110, and the side angle of the projection optical system 30 can be adjusted. The first support base 110 (main unit frame 100) is supported via vibration isolation units 300 so as to be substantially level on the base frame 200. Details of the vibration isolation units 300 are given below.

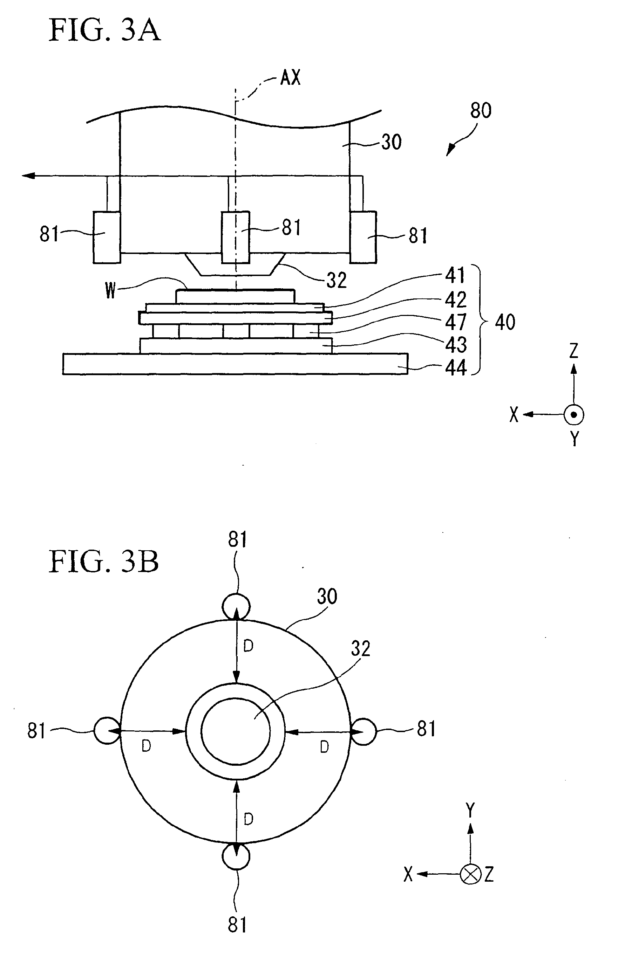

The detection system 80 is placed on the side on the lower portion of the projection optical system 30, and measures the distance between the projection optical system 30 and the wafer W placed on the wafer stage 40 (see FIGS. 3A and 3B). The detection system 80 is described below.

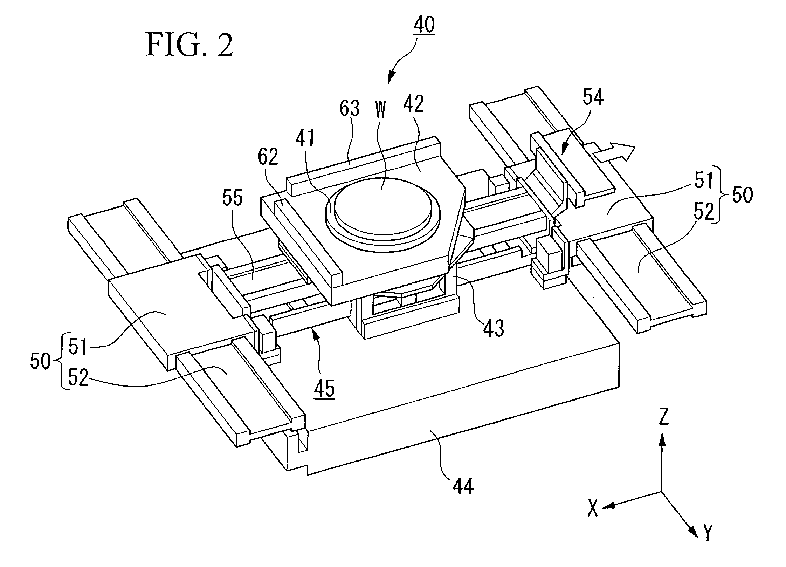

Here, the wafer stage 40 is described in detail, with reference to the drawings. FIG. 2 is a perspective view showing a wafer stage 40.

The wafer stage 40 comprises a wafer holder 41 which holds the wafer W; a wafer table (substrate stage, object) 42, which performs minute driving of the wafer holder 41 in the three degrees of freedom which are the Z-axis direction, X direction, and Y direction, in order to level and focus the wafer W; an XY stage 43, which continuously moves the wafer table 42 in the Y-axis direction and performs step movement in the X-axis direction; a wafer base 44, which supports the XY stage 43 enabling movement in two-dimensional directions along the XY plane; and an X guide bar, which supports the XY stage 43 enabling free relative movement.

On the floor surface of the XY stage 43, a plurality of air bearings (air pads) 46 (not shown in FIG. 2; see FIG. 1), which are non-contact bearings, are fixed in place; by means of these air bearings 46, the XY stage 43 is supported in suspension above the wafer base 44 with for example a clearance of about several microns.

The wafer base 44 is supported substantially horizontally on a support base 210 of the base frame 200 via the vibration isolation unit 200 (see FIG. 1). Details of the vibration isolation units 400 are given below.

The X guide bar 45 is formed in an elongated shape along the X direction; movers 51 comprising armature units are provided at both ends in the length direction. The stators 52 having magnet units corresponding to these movers 51 are provided on support portions 53 protruding from the support base 210 of the base frame 200 (not shown in FIG. 2; see FIG. 1. In FIG. 1, the movers 51 and stators 52 are shown simplified).

A linear motor 50 is formed by these movers 51 and stators 52, and the movers 51 are driven through electromagnetic interaction with the stators 52 to move the X guide bar 45 in the Y direction; by adjusting the driving of the linear motor 50, rotational movement in the Z direction is accomplished. That is, by means of this linear motor 50 the XY stage 43 is driven, substantially integrally with the X guide bar 45, in the Y direction and in the Z direction.

Further, a mover for an X trim motor 54 is mounted on the -X direction side of the X guide bar 45. The X trim motor 54 adjusts the X-direction position of the X guide bar 45 by generating propulsion in the X direction; the stator (not shown) is provided on the base frame 200. By this means, the reaction force when driving the XY stage 43 in the X direction is transmitted on the base frame 200.

The XY stage 43 is supported and held, in contact-free fashion, via a magnetic guide comprising an actuator and magnet which maintain a prescribed gap in the Z direction with the X guide bar 45, enabling free relative motion in the X direction of the X guide bar 45. The XY stage 43 is driven in the X direction through electromagnetic interaction with an X linear motor 55 having a stator embedded in the X guide bar 45. The mover (not shown) of the X linear motor 55 is mounted on the rear side of the XY stage 43. Here, the X linear motor 55 is placed at a position close to the wafer W placed on the XY stage 43, and the mover of the X linear motor 55 is fixed in place on the XY stage 43. Hence it is desirable that as the X linear motor 55 a moving magnet-type linear motor, the stator of which is a coil which is a heat source, be used.

The linear motor 50 integrally drives the X linear motor 55, the X guide bar 45, and the XY stage 43, and so requires far greater propulsion than the X linear motor 55. Consequently a large amount of power is required, and the amount of heat generated is also much greater than for the X linear motor 55. Hence it is desirable that as the linear motor 50 a moving coil type linear motor be used. However, because in a moving coil linear motor it is necessary to circulate cooling liquid to the mover 51, when there are problems related to device configuration, a moving magnet-type linear motor, provided with a magnet on the side of the mover 51, may be used.

The wafer table 42 is placed on the XY stage 43 via a Z actuator (elevating device) 47 (not shown in FIG. 2; see FIG. 3A). The Z actuator 47 comprises a voice coil motor (VCM), and drives the wafer stage 42, placed at three places on the XY stage 43, in the Z axis direction with respect to the XY stage 43, and in the three directions of the X and Y directions. By this means, the wafer W supported on the wafer table 42 by means of the wafer holder 41 can be brought into coincidence with the image-forming plane of the projection optical system 30, and the wafer table 42 can be retracted downward (in the -Z direction) as necessary.

The X-direction position of the wafer table 42 is measured in real time, with prescribed resolution, by a laser interferometer (see FIG. 1), which measures changes in the position of a moving mirror 62 fixed to an end in the X direction of the wafer table 42. The Y-direction position of the wafer table 42 is measured by means of a moving mirror 63 and a laser interferometer (not shown) positioned so as to be substantially perpendicular to the moving mirror 62 and the laser interferometer 61. At least one of these laser interferometers is a multi-axis interferometer having two or more measurement axes; the Z-direction rotation amount and leveling amount of the wafer table 42 (and thus of the wafer W) can be determined based on the measured values of the laser interferometers.

Returning to FIG. 1, the control device 70 executes general control of the exposure apparatus EX, and in addition to a computation portion which performs various computations and control, also comprises a storage portion which records various information, an input/output portion, and the like.

Based for example on detection results of a laser interferometer provided on the reticle stage 20 and wafer stage 40, the positions of the reticle R and wafer W are controlled, and an exposure operation is performed repeatedly in which the image of the pattern PA formed on the reticle R is transferred onto a shot area on the wafer W.

Also, based on measurement results from the detection system 80 described below, the wafer stage 40 or the vibration isolation units 300 and 400 are controlled, to avoid collisions between the projection optical system 30 and the wafer stage 40.

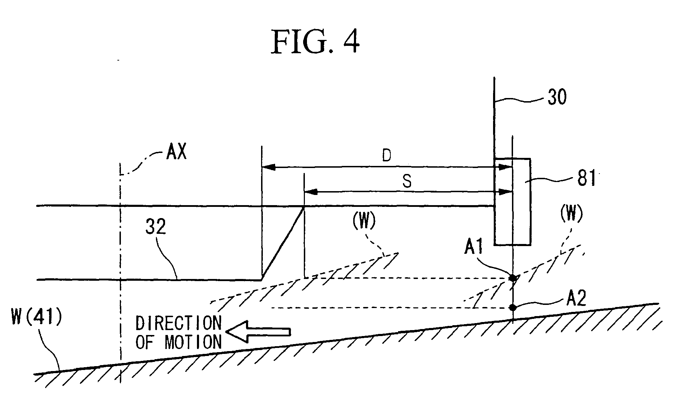

FIGS. 3A and 3B are schematic diagrams showing a detection system 80 and the like; FIG. 3A is a side view, and FIG. 3B is a view of the projection optical system 30 seen from below. FIG. 4 is an enlarged view of the lower end of the projection optical system 30.

As shown in FIGS. 3A and 3B, the detection system 80 is a device which detects the position in the Z direction of the wafer table 42, or of the wafer W placed on the wafer table 42, by means of four position detection sensors (detectors) 81 positioned at the lower end of the projection optical system 30. The four position detection sensors 81 are positioned on both sides of the projection optical system 30 in the scanning direction (X direction) and in the non-scanning direction (Y direction), and detect the position of the wafer W in the Z direction in a contact-free manner, using light, ultrasound, electrostatic capacitance, eddy currents, or the like. When a wafer W is not placed on the wafer table 42, the position detection sensors 81 detect the position in the Z direction of the wafer holder 41.

Further, as shown in FIG. 3B and FIG. 4, the four position detection sensors 81 are placed at positions spaced apart with a distance D from the optical element 32 provided at the bottom end of the projection optical system 30 which is longer than the stopping distance S of the XY stage 43.

Here, the stopping distance S is the distance the XY stage 43 moves when an emergency brake (a linear motor or other dynamic brake driving the XY stage 43) is applied to the XY stage 43 while in motion to stop the stage. The stopping distance is divided into the distance the XY stage 43 moves from the time of a judgment that the XY stage 43 is to be stopped until the dynamic brake begins to be activated (free-running distance), and the distance moved from the time the dynamic brake acts until the XY stage 43 stops (braking distance).

The stopping distance S depends on the speed of motion of the XY stage 43 and the like; the greater the speed of motion of the XY stage 43, the larger is the stopping distance S. Hence the positions at which the position detection sensors.81 are placed, that is, the distance D from the outer periphery of the optical element 32 to the position detection sensors 81, are determined according to the maximum speed of the XY stage 43. The reason for positioning the four position detection sensors 81 at a distance D from the optical element 32 of the projection optical system 30 which is greater than the stopping distance S is explained below.

The height information obtained from the four position detection sensors 81 is sent to the control device 70.

Returning to FIG. 1, the main unit frame 100 comprises a first support base 110 which supports the projection optical system 30, a second support base 120 which supports the reticle stage 20 positioned above the projection optical system 30 and similar, and a plurality of columns 130 arranged in a standing position between the first support base 110 and the second support base 120. As explained above, in the first support base 110 is formed a hole portion 113, formed to be somewhat larger than the outer diameter of the cylindrically-shaped projection optical system 30. In addition to a configuration of being linked by fastening devices or the like, the first support base 110 or second support base 120 and the plurality of columns 130 may be formed integrally.

As explained above, the main unit frame 100 is supported on the base frame 200 via vibration isolation units 300.

The base frame 200 comprises a support base 210 which supports the wafer stage 40 on the upper face via the vibration isolation units 400, and a plurality of columns 220, arranged in a standing position on the support base 210 and which support the main unit frame 100 via the vibration isolation units 300. The support base 210 and columns 220 may be configured in a linked manner by fastening devices or the like, or may be formed integrally.

The base frame 200 is positioned to be substantially level on the floor F of a clean room, via leg portions 215.

The vibration isolation units (vibration isolation device, driving device) 300 are placed at each corner of the first support base 100, and as shown in FIG. 1, are active vibration isolation stands, in which air mounts 310 with adjustable internal pressure and voice coil motors 320 are positioned on the columns 220 of the base frame 200. In FIG. 1, only the vibration isolation units 300 positioned in the X direction are shown; vibration isolation units positioned in the Y direction are omitted from the drawing.

The vibration isolation units (second vibration isolation device, elevating device) 400 are positioned at each of the corners of the wafer base 44, and as shown in FIG. 1, are active vibration isolation stands, in which air mounts 410 with adjustable internal pressure and voice coil motors 420 are arranged in a row on the support base 210. In FIG. 1, only the vibration isolation units 400 positioned in the X direction are shown; vibration isolation units positioned in the Y direction are omitted from the drawing.

On the main unit frame 100 and wafer base 40 which are supported by the vibration isolation units 300 and 400 are mounted position/acceleration sensors 330 and 430 respectively. These position/acceleration sensors 330 and 430 detect the positions and accelerations of the main unit frame 100 and wafer base 40; the detection results are output to the control device 70.

Furthermore, the vibration isolation units 300 are driven based on the detection results of the position/acceleration sensors 330 positioned on the main unit frame 100, to attenuate vibrations transmitted to the main unit frame 100 (and thence to the projection optical system 30) via the base frame 200. Similarly, the anti-vibration units 400 are driven based on the detection results of the position/acceleration sensors 430 mounted on the wafer base 44, to attenuate vibrations transmitted to the wafer stage 40 (and thence to the wafer W) via the base frame 200.

These vibration isolation units 300 and 400 drive the air mounts 310 and 410 based on instructions from the control device 70, and can raise and power the supported positions of the main unit frame 100 or wafer stage 40 which are being supported: That is, the vibration isolation units can raise and lower the main unit frame 100, and the vibration isolation units 400 can raise and lower the wafer stage 40, in the Z direction.

Next, a method of collision avoidance using an exposure apparatus EX with the configuration described above, and in particular using the detection system 80, is explained.

First, after setting the various exposure conditions, prescribed preparation tasks are performed such as reticle alignment, alignment sensor baseline measurements, and similar, using a reticle microscope and off-axis alignment sensor and the like (not shown) and under the control of the control device 70. Then, under the control of the control device 70, fine alignment of the wafer W using the alignment sensor (enhanced global alignment (EGA) and similar) is completed, and the coordinates of a plurality of shot areas on the wafer W are determined.

When preparatory tasks for exposure of the wafer W are completed, liquid (pure water or the like) is supplied from the liquid supply device 91, and a liquid-immersed area is formed on a portion of the wafer W comprising the area for projection by the projection optical system 30. Specifically, the area between the optical element at the end of the projection optical system 30 and the surface of the wafer W is filled with liquid.

Then, while monitoring the measurement values of the X-axis laser interferometer 61 and Y-axis laser interferometer on the side of the wafer W based on the alignment results, the control device 70 issues an instruction to the wafer driving system (linear motor 50 and similar) to move the XY stage 43 to the position of the beginning of acceleration (scan start position) in order to expose the first shot (first shot area) on the wafer W.

Next, the control device 70 issues instructions to the reticle driving system and wafer driving system, scanning of the reticle stage 20 and wafer stage 40 (XY stage 43) in the Y-axis direction is begun, and when the reticle stage 20 and wafer stage 40 reach their respective target scan speeds, a pattern area of the reticle R is illuminated by the exposure light EL, and scanning exposure is begun.

Then, different areas of the pattern on the reticle R are illuminated in succession by the exposure light EL, and when illumination of the entire pattern area is completed, scanning exposure of the first shot area on the wafer W ends. By this means, the circuit pattern PA on the reticle R is reduced and transferred to a resist layer in the first shot area on the wafer W, via the projection optical system 30. When scanning exposure of this first shot area ends, the control device 70 performs step movement of the XY stage 43 in the X- and Y-axis directions, to move to the acceleration starting position for exposure of the second shot area. That is, stepping movement between shots is performed. Then, the above-described scanning exposure of the second shot area is performed.

In this way, stepping movement is repeated for scanning exposure of a shot area and exposure of the next shot area on the wafer W, and the circuit pattern PA of the reticle R is transferred in succession to all the shot areas for exposure on the wafer W.

When this exposure processing is performed, a gap of approximately 1 mm is opened between the projection optical system 30 and the wafer W on the wafer stage 40. However, for various reasons the wafer W moving directly below the projection optical system 30 may be inclined slightly with respect to the optical-axis direction (Z direction) of the projection optical system 30. As a result, when the inclined wafer W moves directly below the projection optical system 30, there is the possibility of interference (collision) between the wafer W and the optical element 32 at the lower end of the projection optical system 30.

Hence the above-described detection system 80 detects the position of the wafer W in the Z direction , and when the value exceeds a prescribed threshold, motion of the XY stage 43 is forcibly stopped.

Specifically, the following operation is performed.

First, the position in the Z direction of position Al in FIG. 4 is stored, as the threshold Z_{A1}, in the control device 70. The position Al is substantially the same position as the Z-direction position of the optical element 32 at the lower end of the projection optical system 30.

Then, while the above-described exposure tasks and similar are being performed, the position in the Z direction of the wafer W is detected by the detection system 80, and the control device 70 continually compares the results of detection by each of the position detection sensors 81 with the threshold Z_{A1}.

When a detection result from a position detection sensor 81 exceeds the threshold Z_{A1}, the control device 70 issues instructions to the linear motor 50 driving the XY stage 43 of the wafer stage 40, the X trim motor 54, and the X linear motor 55, executing control to apply the dynamic brake. That is, a force is made to act in the direction opposite the direction of motion of the XY stage 43, forcibly stopping the XY stage 43.

By this means, the XY stage 43 is stopped before collision with the optical element 32 of the projection optical system 30. That is, the XY stage 43 advances by the distance traveled before being stopped by the dynamic brake (the stopping distance), but the distance D between the optical element 32 and the position distance sensor 81 is greater than the distance S, and so the XY stage 43 is reliably stopped before reaching the optical element 32. In this way, collision of the wafer stage 40 with the projection optical system 30 can be reliably avoided. In this case, software may be used to execute control from detection by the position detection sensor 81 until activation of the dynamic brake, or control may rely solely on hardware processing.

In addition to applying the dynamic break to the linear motor 50, X trim motor 54, and X linear motor 55 driving the XY stage 43, the linear motor 50, X trim motor 54, and X linear motor 55 may be driven in a direction different from the direction of motion, reversing the direction of the XY stage 43, or changing the direction to a direction in which collision does not occur (that is, the direction of moving away from the projection optical system 30).

In addition to merely forcibly stopping the XY stage 43, the wafer table 42 may be lowered. That is, by lowering the wafer table 42 so that the wafer W is moved away from the optical element 32 of the projection optical system 30, collision of the wafer W or wafer table 42 with the projection optical system 30 is avoided. In particular, the wafer table 42 is driven by a Z actuator 57 comprising a VCM, so that the wafer W can be moved away from the optical element 32 at high speed. However, the wafer table 42 has a small stroke, and so it is desirable that, rather than avoiding collisions between the wafer W or wafer table 42 and the projection optical system 30 through driving of the wafer table 42 alone, that this be combined with the forcible stopping of the XY stage 43 described above.

Further, the vibration isolation units 300 may be driven to raise the projection optical system 30. That is, by causing the supported position of the main unit frame 100 to be raised by the air mounts 310 of the vibration isolation units 300, the projection optical system 30 is moved away from the wafer W, and collision of the wafer table 42 and projection optical system 30 is avoided. In particular, the stroke of the vibration isolation units 300 is large compared with that of the wafer table 42, and so the wafer stage 40 can be moved far from the projection optical system 30. However, because of the difficulty in rapidly lifting the projection optical system 30, which is a heavy object, rather than avoiding collisions between the wafer stage 40 and projection optical system 30 solely through driving of the vibration isolation units 300, it is desirable that the above be combined with such methods, described above, as forcible stopping of the XY stage 43 and lowering of the wafer table 42.

Further, the vibration isolation units 400 may be driven to lower the wafer stage 40. That is, by lowering the position at which the wafer stage 40 is supported by the air mounts 410 of the vibration isolation units 400, the wafer table 42 and wafer W are moved away from the projection optical system 30, and collision of the wafer table 42 and projection optical system 30 is avoided. In particular, the stroke of the vibration isolation units 400 is large compared with the Z-direction stroke of the VCM of the wafer table 42, so that the wafer stage 40 can be moved far away from the projection optical system 30. However, compared with the case of raising the projection optical system 30 by means of the vibration isolation units 300, lowering the wafer stage 40 can be performed more rapidly and so is more effective.

However, there are cases in which rapid movement of the XY stage 43 cannot easily be accommodated, and so rather than avoiding collisions between the wafer stage 40 and projection optical system 30 solely by driving the vibration isolation units 400, it is desirable that this be combined with above-described methods such as forcibly stopping the XY stage 43 or lowering the wafer stage 42.

As explained above, by positioning a detection system 80 on the periphery of the projection optical system 30 to detect the Z-direction position of the wafer W, and by forcibly stopping the XY stage 43, lowering the wafer table 42, driving the vibration isolation units 300 and 400 and similar based on the detection results, collisions between the projection optical system 30 and wafer stage 40 can be reliably avoided. As stated above, the methods of forcibly stopping the XY stage 43, lowering the wafer table 42, driving the vibration isolation units 300 and 400, and similar, may be combined.

By this means, the distance between the projection optical system 30 and wafer stage 40 can be reduced, and the wafer W can be exposed to the fine pattern PA.

The operation procedure, and the shapes, combinations and similar of the various component members in the above-described embodiment are one example, but various modifications are possible according to process conditions, design requirements and similar, without deviating from the scope of the gist of the invention. For example, this invention comprises the following modifications.

In this embodiment, position detection sensors 81 are placed on both sides in the scanning direction (X direction) and non-scanning direction (Y direction); but other configurations are possible. A still greater number of position detection sensors 81 may be provided. For example, eight position detection sensors 81 may be positioned uniformly on the outer periphery of the projection optical system 30.

Further, a plurality of position detection sensors 81 were positioned on a circle at the same distance from the projection optical system 30; but other configurations are possible. For example, a plurality of position detection sensors 81 may be positioned on each of a plurality of circles at different distances from the projection optical system 30. By this means, when for example the detection results for position detection sensors 81 positioned at the greatest distance from the projection optical system 30 exceed a threshold, the speed of movement of the XY stage 43 may be constrained (reduced), and when the detection results for position detection sensors 81 positioned at the smallest distance from the projection optical system 30 exceed a threshold, the XY stage 43 may be forcibly stopped. That is, the movement of the XY stage 43 may be controlled in stages to prevent a collision.

Further, a plurality of thresholds (distances in the Z direction) may be provided to avoid collisions. For example, as shown in FIG. 4, when a threshold ZA2 corresponding to a position A2 at which the risk of collision is low is exceeded, collision is avoided by lowering the wafer table 42. Furthermore, when a threshold Z_{A1} corresponding to a position Al at which the risk of collision is high is exceeded, forcible stopping of the XY stage 43, lowering of the wafer table 42 and driving of the vibration isolation units 300 and 400 may be combined to avoid a collision. In other words, an avoidance device may be selected in stages to avoid a collision.

Further, in this embodiment an example was explained in which an optical element 32 of the projection optical system 30 is closest to the wafer W; but in the case of a configuration in which components other than the projection optical system 30, such as for example a wafer alignment system or an auto-focus system, is closest to the wafer W, this invention can be similarly applied. In this case, the position sensors 81 are positioned with the portion closest to the wafer W at the center.

As explained above, ArF excimer laser light is used as the exposure light in this embodiment, and so pure water is supplied as the liquid for liquid-immersion exposure. Pure water has the advantages of being easily obtained in large quantities at semiconductor manufacturing plants and similar, and having no adverse effects on the photoresist on a wafer W or on optical elements (lenses) or the like. Further, pure water has no adverse environmental effects, and contains extremely small amounts of impurities, and so can also be expected to have a cleaning action on the surface of the wafer W and on the surface of the optical element provided at the end of the projection optical system 30.

The refractive index n of pure water (water) for exposure light of wavelength approximately 193 nm is thought to be substantially 1.44. When using ArF excimer laser light (of wavelength 193 nm) as the light source for exposure light, as in this embodiment, the wavelength is shortened to 1/n, that is, to 134 nm on the wafer W, and high resolution is obtained. Further, the depth of focus is increased by approximately n times compared with air, that is, by approximately 1.44 times.

Next, a second embodiment of an exposure apparatus of this invention is explained, with reference to the drawings. Component portions which are the same as or equivalent to those in the embodiment explained above are assigned the same symbols, and explanations are omitted or simplified.

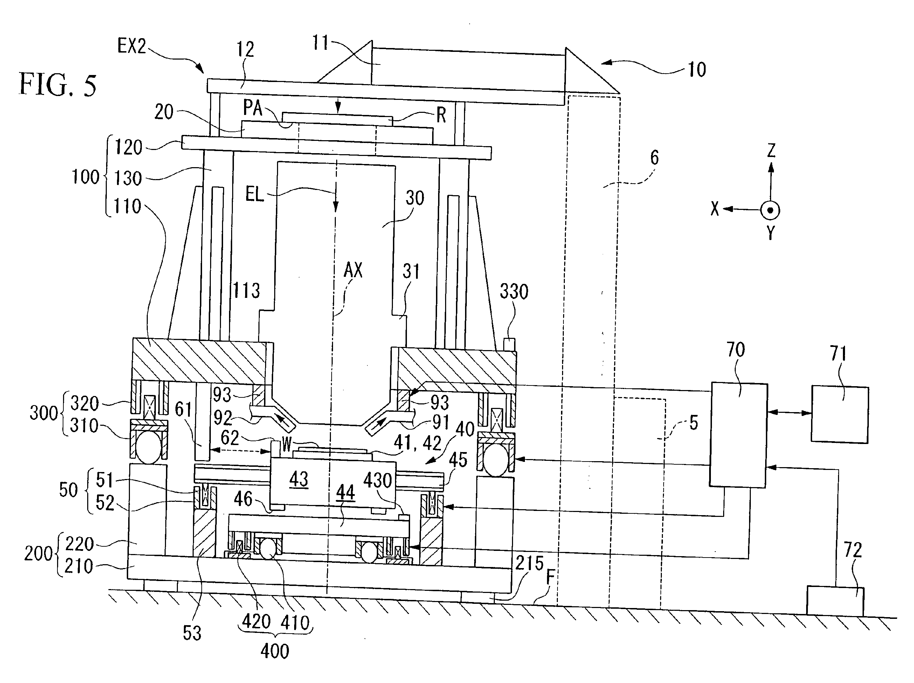

FIG. 5 shows the configuration of an exposure apparatus EX2 of the second embodiment of the invention. The exposure apparatus EX2 of this embodiment comprises an abnormality detector 71. The abnormality detector 71 detects errors occurring in each of the controllers constituting the control device 70, and detects whether an abnormality has occurred in the exposure apparatus EX2.

Here, an abnormality is an operation which may result in a collision between the projection optical system 30, liquid supply device 91, liquid recovery device 92, or other members (opposing members) positioned above the wafer W, and the wafer table 42, wafer W, or other members (objects) positioned below the projection optical system 30, possibly resulting in damage to the apparatus. Specifically, due to the occurrence of skips (miscounts and similar) in the measured value of the laser interferometer 61, the intrusion of noise into driving instruction values for the linear motors 50 and 55 and similar, runaway operation of the XY stage 43 may occur. Or, due to abnormalities with the internal pressure of the air mounts 410 constituting the vibration isolation units 300, or to the intrusion of noise into driving instruction values for the voice coil motor 320 or the like, control of the vibration isolation units 300 may become impossible, or the position of the main unit frame 100 may become indeterminate.

When such an abnormality occurs, an interference measurement error, XY stage 43 control error, vibration isolation unit 300 positioning error, or the like occur in the interference measurement controller, wafer stage controller, and vibration isolation unit controller and similar, respectively, which are constituting the control device 70; hence the abnormality detector 71 detects these errors, judges whether an abnormality has occurred, and, when an abnormality has occurred due to which there is danger of damage to the exposure apparatus EX2, notifies the control device 70 of this fact.

An earthquake detection device 72, provided outside the exposure apparatus EX2, is connected to the control device 70. The earthquake detection device 72 is installed on the floor F on which the exposure apparatus EX2 is installed, and upon detecting abnormal vibration of the floor F due to an earthquake or the like, notifies the control device 70 of this abnormality. The earthquake detection device 72 notifies the control device 70 of the occurrence of abnormal vibrations only in cases of abnormal vibrations exceeding a level at which damage to the exposure apparatus EX2 may result; upon analyzing the direction of vibration, the vibration amplitude, frequency, and other factors, and judging vibrations to be local vibrations which pose no danger of harm to the exposure apparatus EX2 (for example, vibrations caused by the passage of some load or the like close to the earthquake detection device 72), no notification is issued.

The liquid supply device 91 and liquid recovery device 92 provided on the periphery of the projection optical system 30 are supported by the first support base 110 via the driving device 93. While the exposure apparatus EX2 is operating normally, the driving device 93 positions the liquid supply device 91 and liquid recovery device 92 in prescribed positions, removed prescribed distances from the surface of the wafer W. In response to an instruction from the control device 70, the liquid supply device 91 and liquid recovery device 92 are lifted along the direction of the optical axis of the projection optical system 30 (the Z direction).

Next, operation of the exposure apparatus EX2 of the second embodiment of the invention is explained. As described above, while the exposure apparatus EX2 is operating normally, the driving device 93 positions the liquid supply device 91 and liquid recovery device 92 at prescribed positions, removed prescribed distances from the surface of the wafer W.

Here, when an abnormality occurs in the exposure apparatus EX2, the abnormality detector 71 detects an error occurring in the control device 70, verifies whether the detected error is relevant to an error stored in advance, and if relevant, notifies the control device 70 of the error. Here, an error stored in advance is an error which may result in damage to the exposure apparatus EX2.

Upon receiving notification from the abnormality detector 71, the control device 70 drives the driving device 93 corresponding to the notification and raises the liquid supply device 91 and liquid recovery device 92 away from the wafer W. At the same time, the control device 70 controls the vibration isolation units 300 to raise the main unit frame 100, as well as controlling the vibration isolation units 400 to lower the wafer base 44. Further, the control device 70 controls the Z actuator 47 to lower the wafer table 42.

Further, when the earthquake detection device 72 detects an earthquake, the control device 70, upon receiving notification of the occurrence of the earthquake, performs control similar to that described above.

As explained above, upon receiving notification of occurrence of an abnormality, the control device 70 performs the above control to move the liquid supply device 91 and liquid recovery device 92 away from the wafer W and similar, so that there is no interference between the liquid supply device 91 and liquid recovery device 92 and the wafer W and similar and no damage to the exposure apparatus EX2, and restoration of the exposure apparatus EX2 after the abnormality, as well as resumption of manufacture of semiconductor devices, can be accomplished quickly.

In this embodiment, an example was explained in which an abnormality detector 71 is provided separately from the control device 70; but a separate abnormality detector 71 need not necessarily be provided as a dedicated device. When an abnormality detector 71 is not provided separately, among the individual controllers constituting the control device 70, it is sufficient that the lower-level controllers which directly control the individual action portions of the exposure apparatus EX2 function as an abnormality detector, and notify the higher-level controllers executing integrated control of the lower-level controllers of the occurrence of an abnormality. Upon receiving such notification, a higher-level controller should then issue a control instruction to each of the lower-level controllers so as to perform the above-described operations.

Further, in this embodiment an example was explained in which the earthquake detection device 72 is installed on the floor F on which the exposure apparatus EX2 is installed; but the earthquake detector 72 may be installed in other places as well. For example, the device may be installed on the ground at the site of the building housing the exposure apparatus EX2.

Further, in the above a case was explained in which the control device 70, upon receiving notification of the occurrence of an abnormality, performs the four operations of raising the liquid supply device 91 and liquid recovery device 92, raising the main unit frame 100, lowering the wafer base 44, and lowering the wafer table 42; however, these need not necessarily all be performed, and at least one of these operations may be performed. However, these operations are performed upon occurrence of an abnormality, and so there may be cases in which a planned operation cannot be executed due to occurrence of an error. Hence it is desirable that the control device 70 attempt to execute as many operations as possible upon receiving notification of the occurrence of an abnormality. Further, the optimum operation may be selected and executed according to the abnormality which has occurred. Of course the control device 70 may execute control to perform operations other than those described above in order to avoid damage to the exposure apparatus EX2.

Further, a configuration may be employed in which, in anticipation of power outages or other circumstances accompanying the occurrence of an earthquake, the above operations are performed by means of hardware, without software intervention. For example, a pressurized air tank is connected, via a normally-open electromagnetic valve, to the air mounts 310 of the vibration isolation units 300. Further, a normally-open electromagnetic valve is installed at the air mounts 410 of the vibration isolation units 400 also, and one end is left open to the atmosphere. In the normal state of both these electromagnetic valves, current is passed and the valve is in the closed state; but in the event of a power outage, in response to notification of an abnormality in the form of the stoppage of current, each of the electromagnetic valves is opened, and automatic operation is performed without software intervention. By this means air is conveyed to the air mounts 310 and air is released from the air mounts 410, so that the main unit frame 100 and the liquid supply device 91, liquid recovery device 92 and projection optical system 30 supported by the main unit frame 100 are raised, the wafer table 42 and wafer W are lowered, and damage to the exposure apparatus EX2 can be prevented.

In this embodiment, an example was explained in which the driving device 93 drives the liquid supply device 91 and liquid recovery device 92; but the driving device may drive other members opposing the wafer W as well. For example, an auto-focus system or wafer alignment system may be driven. Further, in order that some degree of contact cause no damage, the liquid supply device 91 and liquid recovery device 92 may be supported by the driving device 93 via an elastic member (rubber, a spring, or the like) to absorb shocks.

Further, as the liquid used, any other liquid which is translucent to the exposure light, having as high a refractive index as possible, and which is stable with respect to the projection optical system 30 and to the photoresist applied to the surface of the wafer W, can be used.

When using F₂ laser light as the exposure light, a fluoride oil, perfluorinated polyether (PFPE), or other fluoride liquid which can transmit F₂ laser light, may be used as the liquid.

In the above-described embodiment, an exposure apparatus in which the space between the projection optical system 30 and wafer W is locally filled with a liquid was adopted; but this invention can also be applied to liquid-immersion an exposure apparatus such as that disclosed in Japanese Unexamined Patent Application, First Publication No. H6-124873, in which the stage holding the wafer for exposure is moved within a liquid container, and to liquid-immersion an exposure apparatus such as that disclosed in Japanese Unexamined Patent Application, First Publication No. H10-303114 , in which a liquid container of prescribed depth is formed on the stage, and the wafer is held therein.

Further, this invention can also be applied to twin-stage type an exposure apparatus comprising two stages, independently movable in the XY directions, on which are separately placed wafers or other substrates for processing, such as are disclosed in Japanese Unexamined Patent Application, First Publication No. H10-163099 , Japanese Unexamined Patent Application, First Publication No. H10-214783 , and Published Japanese Translation of PCT Application 2000-505958.

Further, this invention can also be applied to an exposure stage comprising two stages, independently movable and with different functions. Specifically, this invention can be applied to an exposure apparatus comprising two stages, one of which is a movable stage for exposure which holds a wafer W, and the other of which is a stage for measurement purposes having measurement functions to measure the imaging performance of the projection optical system and the like; and the above-described avoidance operations can be performed upon occurrence of an abnormality in either of the stages.

As explained above, when using a liquid immersion method, the numerical aperture NA of the projection optical system may be from 0.9 to 1.3. When the numerical aperture NA of the projection optical system becomes this large, random polarized light used as the exposure light in the prior art may result in degradation of imaging performance due to polarization effects, and so it is desirable that polarized illumination be used. In this case, linearly polarized illumination which is polarized in the length direction of the line patterns in the line-and-space pattern of the reticle may be used, with numerous diffracted rays of the S polarization component (the component polarized in the direction along the length direction of the line pattern) emitted from the pattern of the mask (reticle). When the space between the projection optical system and the resist applied to the wafer surface is filled with a liquid, compared with a case in which the space between the projection optical system and resist is filled with a gas (air), the transmissivity at the resist surface of diffracted rays of the S polarization component, contributing to improved contrast, is increased, so that even when the numerical aperture NA of the projection optical system exceeds 1.0, high image-forming performance can be obtained. Still greater effectiveness is obtained by combining as appropriate a phase-shift mask and an oblique-incidence illumination method (in particular a dipole illumination method) according to the line pattern length direction, as disclosed in Japanese Unexamined Patent Application, First Publication No. 6-188169 , and the like.

In addition to linearly polarized illumination (S polarization illumination) in the length direction of the line pattern of the reticle, it is effective to combine an oblique incidence illumination method and polarized illumination method which uses linearly polarized light in directions tangential (circumferential) to a circle centered on the optical axis, as disclosed in Japanese Unexamined Patent Application, First Publication No. H6-53120. In particular, when the reticle pattern is not a line pattern extending in a prescribed constant direction, but includes patterns extending in a plurality of different directions, by combining a polarized illumination method employing light linearly polarized in directions tangential to a circle centered on the optical axis and a zone illumination method, as disclosed in the same Japanese Unexamined Patent Application, First Publication No. H6-53120 , high image-forming performance can be obtained even when the numerical aperture NA of the projection optical system is large.

The exposure apparatus to which this invention is applied is not limited to liquid immersion-type an exposure apparatus.

Further, step-and-repeat type an exposure apparatus, in which exposure to the mask pattern is performed with the mask and substrate in a stationary state, and the substrate is moved in successive steps, may also be used.

Further, as the exposure apparatus to which this invention is applied, proximity an exposure apparatus, in which the mask and substrate are in close contact to expose the mask pattern, without using a projection optical system, may also be used.

Further, uses of the exposure apparatus are not limited to an exposure apparatus for semiconductor device manufacturing, but broad application to an exposure apparatus for liquid crystal devices, in which rectangular glass plates are exposed to liquid crystal device patterns, as well as to an exposure apparatus for manufacture of thin film magnetic heads, is also possible.

The light source of the exposure apparatus to which this invention is applied is not limited to the g line (436 nm), i line (365 nm), KrF excimer laser light (248 nm), ArF excimer laser light (193 nm), or F₂ laser light (157 nm), and X-rays, electron beams, and other charged particle beams can also be used. For example, when using an electron beam, thermal electron emission-type lanthanum hexaborite (LaB₆) and tantalum (Ta) can be used as the electron gun. Further, when using an electron beam, a configuration in which a mask is employed may be used, or a configuration may be employed in which the pattern is formed directly on the substrate without using a mask. Further, the magnification of the projection optical system need not be such that the system is a reducing system, and a same-size system or enlarging system may also be used.

As the projection optical system, when employing an excimer laser or other far-ultraviolet light, quartz, fluorite, or another material which transmits far-ultraviolet light is used as the optical material, and when using F₂ laser light or X-rays, a reflective-refractive or refractive optical system may be used (in this case, a reflection-type reticle is employed); and when using an electron beam, an electron optical system comprising electron lenses and deflectors is used as the optical system. Of course the optical path through which the electron beam passes is put into a vacuum state.

Further, when using a linear motor in the wafer stage or reticle stage, either an air-suspension type configuration employing air bearings, or a magnetic-suspension configuration employing Lorentz forces ore reactance forces, may be employed. The stages may move along guides, or may be guideless-type stages with no guides provided. Further, when using a planar motor as the stage driving device, one of the magnet unit (permanent magnet) and armature unit is connected to the stage, and the other among the magnet unit and armature unit is provided on the side of the surface (base) on which the stage moves.

The reaction force occurring due to movement of the wafer stage may be released mechanically to the floor (earth) using a frame member as disclosed in Japanese Unexamined Patent Application, First Publication No. H8-166475 .

The reaction force occurring due to movement of the wafer stage may be cancelled by movement of a countermass in the direction opposite the direction of movement of the wafer stage.

The reaction force occurring due to movement of the reticle stage may be released mechanically to the floor (earth) using a frame member as disclosed in Japanese Unexamined Patent Application, First Publication No. H8-330224.

An exposure apparatus to which this invention is applied is manufactured by assuming the various subsystems, comprising the component elements described in the scope of claims of the invention, so as to maintain prescribed mechanical precision, electrical precision, and optical precision. In order to secure this precision, before and after the assembly, adjustments of each of the optical systems are performed to attain the optical precision required, adjustments of each of the mechanical systems are performed to attain the mechanical precision required, and adjustments of each of the electrical systems are performed to attain the electrical precision required. The process of assembly of each of the subsystems into the exposure apparatus comprises mechanical connection, wiring connection of electrical circuits, tubing connection of air paths, and similar between the various subsystems. Prior to the process of assembly of the various subsystems into the exposure apparatus, of course each of the subsystems must be assembled individually. After completion of the process of assembly of the various subsystems into the exposure apparatus, comprehensive adjustments are performed, and the various precision values of the exposure apparatus as a whole are secured. It is desirable that manufacture of the exposure apparatus be performed in a clean room with the temperature and cleanliness controlled.

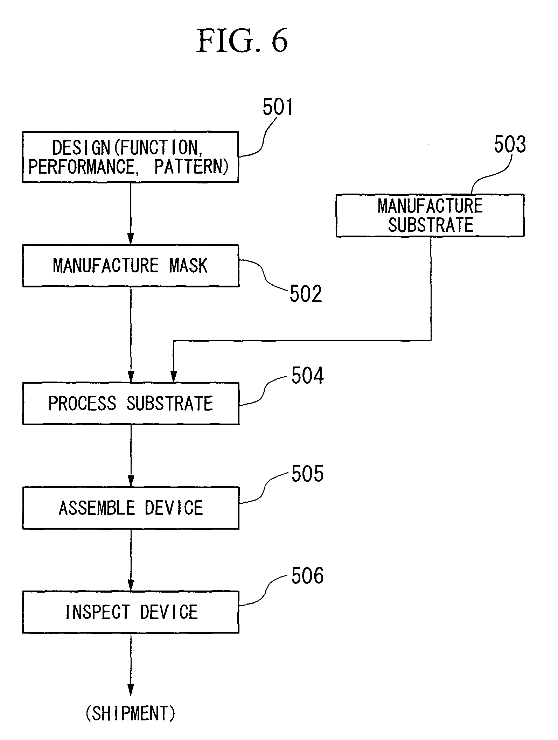

As shown in FIG. 6, semiconductor devices are manufactured by means of a process 501 of device function/performance design; a process 502 of manufacturing a mask (reticle) based on this design step; a process 503 of manufacturing wafers from silicon material; a wafer treatment process 504 of exposing wafers to the pattern of the reticle by means of an exposure apparatus such as described in the above embodiments; a device assembly process 505 (comprising a dicing process, bonding process, and packaging process); and an inspection process 506.

ITEMS:
1. An exposure apparatus, comprising a projection optical system which projects and transfers a pattern formed on a mask onto a substrate, and a substrate stage, positioned below said projection optical system, which while holding said substrate moves in directions substantially perpendicular to the direction of the optical axis of said projection optical system, comprising: a detector, positioned on a periphery of said projection optical system, which detects the position of said substrate stage or of said substrate along said optical axis direction; and a control device, which halts or reverses movement of said substrate stage based on the result of detection by said detector.
2. The exposure apparatus according to item 1, further comprising an elevating device which moves said substrate stage in said optical axis direction, wherein said control device operates said elevating device based on detection results of said detector to move said substrate stage away from said projection optical system along said optical axis direction.
3. The exposure apparatus according to item 2, wherein said detector is positioned in a plurality of positions, at greater distances from said projection optical system in directions substantially perpendicular to said optical axis direction than the stopping distance of said substrate stage.
4. The exposure apparatus according to item 1, further comprising an vibration isolation device which supports said projection optical system while preventing vibrations, movably along said optical axis direction, wherein said control device operates said vibration isolation device to raise said projection optical system in said optical axis direction, based on detection results of said detector.
5. The exposure apparatus according to item 1, further comprising a second vibration isolation device which supports said substrate stage while preventing vibrations, movably along said optical axis direction, wherein said control device operates said second vibration isolation device to lower said substrate stage in said optical axis direction, based on detection results of said detector.
6. An exposure apparatus, comprising: a projection optical system which projects and transfers a pattern formed on a mask onto a substrate, and a substrate stage, positioned below said projection optical system, which while holding said substrate moves in directions substantially perpendicular to the direction of the optical axis of said projection optical system, comprising: a detector, positioned on a periphery of said projection optical system, which detects the position of said substrate stage or of said substrate along said optical axis direction; an vibration isolation device, which supports said projection optical system so as to prevent vibrations, movably along said optical axis direction; a second vibration isolation device, which supports said substrate stage so as to prevent vibrations, movably along said optical axis direction; and a control device, which, based on detection results of said detector, controls at least one of said vibration isolation device and said second vibration isolation device to move said substrate stage and said projection optical system, or said substrate and said projection optical system, along said optical axis direction.
7. An exposure apparatus, in which the space between a projection optical system which projects a pattern onto an object and an object placed on the image-plane side of said projection optical system is filled with a liquid, and exposure to said pattern is performed through the liquid, comprising: an opposing member, positioned apart from said object in the direction of the optical axis of said projection optical system; and a control device, which, in response to notification of occurrence of an abnormality, moves said object and said opposing member apart along said optical axis direction.
8. The exposure apparatus according to item 7, wherein said control device, in response to notification of occurrence of an earthquake, moves said object and said opposing member apart along said optical axis direction.
9. The exposure apparatus according to item 8, wherein said object is movable within the plane perpendicular to said optical axis, and said control device, in response to notification of abnormal operation of said object, moves said object and said opposing member apart along said optical axis direction.
10. The exposure apparatus according to item 8 or 9, further comprising an elevating device which moves said object in said optical axis direction and a driving device which drives said opposing member in said optical axis direction, wherein said control device controls at least one of said elevating device and said driving device to move apart said object and said opposing member along said optical axis direction.
11. The exposure apparatus according to item 10, further comprising a first frame which supports said opposing member, and wherein said driving device is an vibration isolation device which supports said opposing member, movably in said optical axis direction, through said first frame.
12. The exposure apparatus according to item 11, further comprising a second vibration isolation device which supports said object movably along said optical axis direction, wherein said control device controls at least one of said elevating device, said vibration isolation device, and said second vibration isolation device to move apart said object and said opposing member along said optical axis direction.
13. The exposure apparatus according to item 10, wherein said driving device drives said opposing member, relative to said projection optical system, in said optical axis direction.
14. The exposure apparatus according to item 7, wherein said object is a substrate for exposure to said pattern or a substrate stage holding said substrate, and movable with at least three degrees of freedom.
15. The exposure apparatus according to item 7, wherein said opposing member comprises at least one of a liquid supply device which supplies liquid to the space between said projection optical system and said object, and a liquid recovery device which recovers said liquid.
16. A device manufacturing method, comprising a lithography process, wherein in said lithography process, an exposure apparatus according to any one of items 1 through 15 is used.

## Claims

1. An exposure apparatus (EX, EX2), in which the space between a projection optical system (30) which projects a pattern (PA) onto an object (W, 42) and said object placed on the image-plane side of said projection optical system is filled with a liquid, and exposure to said pattern is performed through the liquid, comprising:
an opposing member (91, 92), positioned apart from said object (W, 42) in the direction of the optical axis (AX) of said projection optical system (30), a driving device (93) to drive the opposing member (91, 92) and
a control device (70), which, in response to notification of occurrence of an abnormality, moves said object and said opposing member apart along said optical axis direction,
**characterised in that**
the opposing member (91, 92) is movable, relative to the projection optical system (30), in the optical axis direction (AX) .

2. Exposure apparatus (EX, EX2) according to claim 1, further comprising a first frame (110) which supports the opposing member (91, 92), wherein the driving device is constituted by a vibration isolation device (300) which supports the opposing member (91, 92), movably in the optical axis direction (AX), via the first frame (110).

3. Exposure apparatus (EX, EX2) according to claim 1 or 2, further comprising an elevating device (47) which is capable of moving the object (W, 42) in the optical axis direction (AX), wherein the control device (70) controls at least one of the elevating device (47) and the vibration isolation device (300) to move apart the object (W, 42) and the opposing member (91, 92) along the optical axis direction (AX).

4. The exposure apparatus (EX, EX2) according to any of claims 1 to 3, wherein said object (W, 42) is movable within the plane perpendicular to said optical axis (AX), and said control device (70), in response to notification of abnormal operation of said object (W, 42), moves said object (W, 42) and said opposing member (91, 92) apart along said optical axis direction (AX).

5. The exposure apparatus (EX, EX2) according to any of claims 1 to 4, further comprising a second vibration isolation device (400) which supports said object (W, 42) movably along said optical axis direction (AX),
wherein said control device (70) controls at least one of said elevating device (47), said vibration isolation device (300), and said second vibration isolation device (400) to move apart said object (W, 42) and said opposing member (91, 92) along said optical axis direction (AX).

6. The exposure apparatus (EX, EX2) according to claim any of claims 1 to 5, wherein said object (W, 42) is a substrate (R) for exposure to said pattern (PA) or a substrate stage (42) holding said substrate (R), and movable with at least three degrees of freedom.

7. The exposure apparatus (EX, EX2) according to any of claims 1 to 6, wherein said opposing member (91, 92) comprises at least one of a liquid supply device (91) which supplies liquid to the space between said projection optical system (30) and said object (W, 42), and a liquid recovery device (92) which recovers said liquid.

8. The exposure apparatus (EX, EX2) according to any of claims 1 to 7, wherein said control device (70), in response to notification of occurrence of an earthquake, moves said object (W, 42) and said opposing member (91, 92) apart along said optical axis direction (AX).

9. A device manufacturing method, comprising a lithography process, wherein in said lithography process, an exposure apparatus (EX) according to any one of Claims 1 through 8 is used.
